# EUROPÄISCHE PATENTSCHRIFT

(11) **EP 0 878 988 B1**
(45) Veröffentlichungstag und Bekanntmachung des Hinweises auf die Patenterteilung: **30.06.2004**
(21) Anmeldenummer: 98106272.2
(22) Anmeldetag: 06.04.1998
(51) Int. Cl.: H05K 5/02, H02G 3/12

(54) **Türanlage**
Door arrangement
Installation pour portes d'entrée

(30) Priorität: 16.05.1997 DE 19720727
(43) Veröffentlichungstag der Anmeldung: 18.11.1998
(73) Patentinhaber: S. Siedle & Söhne Telefon- und Telegrafenwerke Stiftung & Co., 78120 Furtwangen (DE)
(72) Erfinder: Versemann, Rolf, Dipl. Ing. FH, 78098 Triberg (DE)
(74) Vertreter: Patentanwälte Leinweber & Zimmermann

(56) Entgegenhaltungen:
- EP-A- 0 060 395
- DE-A- 4 143 337
- DE-C- 4 009 190
- DE-U- 8 700 435

## Beschreibung

Die Erfindung betrifft eine Türanlage mit mindestens einem Kombinationsrahmen, mindestens zwei Montagerahmen und mindestens zwei Fünktionsmodulen, wobei die Montagerahmen dazu ausgelegt sind, jeweils ein Funktionsmodul aufzunehmen, der Kombinationsrahmen dazu ausgelegt ist, mindestens zwei Montagerahmen aufzunehmen und zwei erste Verriegelungseinrichtungen zum Verriegeln jeweils eines Funktionsmoduls in einem Montagerahmen vorgesehen sind.

Türanlagen der eingangs genannten Art sind bekannt, beispielsweise aus der DE-C-40 09 190.

Aus der EP-B-60395 ist eine Türanlage bekannt bei der die Montagerahmen mittels einer scharnierartigen Einrichtung in den Kombinationsrahmen eingehängt werden. Die scharnierartige Einrichtung ist dabei in der Draufsicht neben, ober- oder unterhalb der Funktionsmodule angeordnet. Ferner ist bei der aus der EP-B-60395 bekannten Türanlage ein Schloß auf der der scharnierartigen Einrichtung gegenüberliegenden Seite des Kombinationsrahmens vorgesehen. Mithin liegt auch das Schloß neben, unter- oder oberhalb der Funktionsmodule, und zwar in der Draufsicht sichtbar und zugänglich. Ferner führen sowohl die scharnierartige Einrichtung als auch das Schloß dazu, daß selbst dann ein Raster nicht konsequent durchgehalten werden kann, wenn die Funktionsmodule sämtlich in der Draufsicht gleiche Außenabmessungen haben, nämlich beispielsweise quadratisch sind. Dieses Durchbrechen des Rasters führt zu Schwierigkeiten beim Aneinanderreihen mehrerer Module und resultiert letztlich in einer nur beschränkten Flexibilität des Gesamtsystems.

Die bereits erwähnte Türanlage nach der DE-C-40 09 190 löst die oben dargestellten Probleme teilweise. Die Lösung sieht eine konsequentere Modularität vor, indem Montagerahmen nicht wie nach der EP-B-60395 zu größeren Einheiten kombiniert und mittels einer gemeinsamen scharnierartigen Einrichtung und eines gemeinsamen Schloßes an dem Kombinationsrahmen angebracht werden, sondern indem jeder Montagerahmen mittels einer eigenen Verriegelungseinrichtung an dem Kombinationsrahmen befestigt wird. Die Verriegelungseinrichtungen sind dabei in Form von Schnappnasen ausgeführt, die entsprechende Rasten hintergreifen. Damit diese Verriegelungseinrichtungen die einzelnen Montagerahmen verläßlich an dem Kombinationsrahmen halten, ist es aber erforderlich, die genannten Schnappnasen und Rasten an mindestens zwei einander gegenüberliegenden Seiten des Montagerahmens vorzusehen und zu benutzen. Daher muß jeder Montagerahmen an mindestens zwei Seiten mit einer entsprechenden Verriegelungseinrichtung an dem Kombinationsrahmen befestigt werden. Dies ist möglich, solange die Montagerahmen nur in einer Reihe nebeneinanderliegen (Verriegelung an zwei einander gegenüberliegenden Seiten).

Demgegenüber ist es aber mit dem beschriebenen System beispielsweise nicht möglich, vier Montagerahmen im Karree anzuordnen, weil die jeweils in den Reihen und Spalten auf dem Mittelplatz angeordneten Montagerahmen sowie der zentrale Montagerahmen keine zwei Seiten mit dem Kombinationsrahmen gemeinsam haben, an denen sie gehalten werden könnten.

Der Erfindung liegt die Aufgabe zugrunde, eine Türanlage der eingangs genannten Art zu schaffen, mit der es möglich ist, Montagerahmen bzw. Funktionsmodule in zwei und mehr Reihen oder Spalten in einem Kombinationsrahmen zu befestigen, und zwar ohne Durchbrechung eines durch die Draufsicht-Außenabmessungen der Funktionsmodule vorgegeben Rasters.

Erfindungsgemäß wird die gestellte Aufgabe dadurch gelöst, daß die Montagerahmen starr miteinander verbunden sind, und zwar derart, daß die von ihnen aufgenommenen Funktionsmodule in einer Reihe nebeneinander liegen, in der Draufsicht die Außenkontur der miteinander verbundenen Montagerahmen nicht über die Stirnseiten und die Längsseiten der Reihe Funktionsmodule übersteht und eine der Verriegelung der miteinander verbundenen Montagerahmen in dem Kombinationsrahmen dienende zweite Verriegelungseinrichtung derart angeordnet ist, daß sie von aufgenommenen Funktionsmodulen verdeckt wird und dadurch unzugänglich ist.

Mit anderen Worten durchbricht die Erfindung das in der DE-C-40 09 190 beschriebene Prinzip der konsequenten Modularität, indem Montagerahmen durch starre Verbindung zu Gruppen zusammengeschlossen werden, was dazu führt, daß nicht einheitliche Standard-Montagerahmen, sondern jeweils Zweier-, Dreier-, Vierer- usw. Kombinationen von Montagerahmen hergestellt und bevorratet werden müssen. Grade diese Durchbrechung des Modularitätsprinzips führt aber zu mehr Kombinationsmöglichkeiten. Es kann nämlich beispielsweise das oben bereits beschriebene Karree mit zwei Spalten und zwei Reihen Montagerahmen bzw. Funktionsmodule verwirklicht werden, weil die Montagerahmen durch ihre Verbundenheit miteinander sich gegenseitig genügend Halt geben, so daß eine Anbringung an dem Kombinationsrahmen nur noch an den Außenseiten der Montagerahmen-Kombinationen erforderlich ist. Im Falle eines dreireihigen und dreispaltigen Karrees können beispielsweise jeweils die drei Montagerahmen einer Spalte durch starre Verbindung miteinander zu einer Einheit kombiniert sein, die an den beiden Stirnseiten der so entstandenen Reihe, also an mit dem Kombinationsrahmen gemeinsamen Seiten an dem Kombinationsrahmen verriegelt ist.

Wegen der Tatsache, daß die Außenkontur der miteinander verbundenen Montagerahmen in der Draufsicht nicht über die Stirnseiten und die Längsseiten der Reihe Funktionsmodule übersteht, ist gewährleistet, daß ein durch die Außenabmessungen der Funktionsmodule in der Draufsicht vorgegebenes Raster nicht durchbrochen wird. Das gleiche gilt für die Tatsache, wonach die zweite Verriegelungseinrichtung, also die für die Verriegelung der miteinander verbundenen Montagerahmen in dem Kombinationsrahmen vorgesehene Verriegelungseinrichtung derart angeordnet ist, daß sie von aufgenommenen Funktionsmodulen verdeckt wird.

Wegen dieser Unzugänglichkeit der zweiten Verriegelungseinrichtung muß kein von außen sichtbares und daher ein eventuelles Raster durchbrechendes Schloß für die zweite Verriegelungseinrichtung vorgesehen sein. Vielmehr genügt eine manipulationssichere Verriegelung der Funktionsmodule in den Montagerahmen. Denn wegen der Unzugänglichkeit der zweiten Verriegelungseinrichtung bei eingesetztem Funktionsmodul können die Montagerahmen nicht entriegelt werden, solange die Funktionsmodule eingesetzt sind.

Die zweite Verriegelungseinrichtung kann mindestens eine Schraube zum Einschrauben in eine Rückwand des Kombinationsrahmens oder in eine den Kombinationsrahmen haltende Unter- oder Aufputzdose beinhalten.

Zusätzlich oder - insbesondere bei sehr flach bauenden Einheiten - alternativ kann auch vorgesehen sein, daß die zweite Verriegelungseinrichtung mindestens eine elastisch in Schließrichtung vorgespannte Schnappnase an den miteinander verbundenen Montagerahmen oder dem Kombinationsrahmen beinhaltet, die im Verriegelungszustand eine Raste an dem Kombinationsrahmen oder den miteinander verbundenen Montagerahmen hintergreift.

Bei dieser Ausgestaltung der zweiten Verriegelungseinrichtung sind die Verriegelung und die Entriegelung der Montagerahmen in dem Kombinationsrahmen besonders einfach zu bewerkstelligen.

Insbesondere bei einer großen Zahl von Montagerahmen und Funktionsmodulen kann es aus Gründen der Stabilität erforderlich oder zumindest wünschenswert sein, eine Stabilisierungsrippe vorzusehen, die lösbar derart an dem Kombinationsrahmen befestigt ist, daß sie im Inneren des Kombinationsrahmens und parallel zu einer seiner Seiten liegt.

Eine solche Stabilisierungsrippe kann eine für die Verriegelung von Montagerahmen in dem Kombinationsrahmen erforderliche Seite des Kombinationsrahmens ersetzen und somit eine "Zwischenstütze" für lange Reihen Montagerahmen bzw. Funktionsmodule darstellen.

Im folgenden ist die Erfindung anhand bevorzugter Ausführungsbeispiele unter Bezugnahme auf die beiliegende Zeichnung mit weiteren Einzelheiten näher erläutert. Dabei zeigen
- Fig. 1: eine perspektivische Ansicht zweier Montagerahmen,
- Fig. 2: perspektivisch eine Kombination von vier Montagerahmen mit zwei zur Aufnahme darin vorgesehenen Funktionsmodulen,
- Fig. 3: eine Schnittansicht einer Verriegelungseinrichtung,
- Fig. 4: ein Sortiment von Einzelteilen für eine Türanlage,
- Fig. 5: perspektivisch einen Montagerahmen und eine Stabilisierungsrippe,
- Fig. 6: verschiedene Kombinationsmöglichkeiten für eine Türanlage, und
- Fig. 7: perspektivisch verschiedene Einzelelemente einer Türanlage.

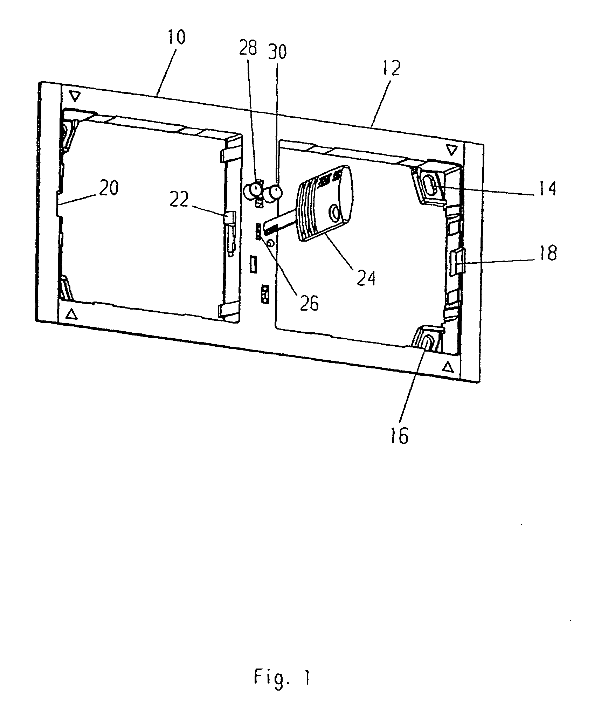

Fig. 1 zeigt zwei starr miteinander verbundene Montagerahmen 10, 12 in der Perspektive. Sie weisen verschiedene Befestigungseinrichtungen zur Anbringung an einem Kombinationsrahmen auf. So sind beispielsweise Augen 14 und 16 vorgesehen, durch die Schrauben hindurchgesteckt werden können, die in entsprechende Bohrungen entweder in dem Kombinationsrahmen oder in einer den Kombinationsrahmen haltenden Aufoder Unterputzdose eingeschraubt werden.

Ferner weisen die Rahmen Ausnehmungen 18 und 20 auf, deren Unterkante jeweils eine Raste zur Verriegelung mit einer elastisch in Schließrichtung vorgespannten Schnappnase an dem Kombinationsrahmen dient. Zur Verriegelung von Funktionsmodulen dienen ebenfalls in Schließrichtung elastisch vorgespannte Schnappnasen von denen in Fig. 1 eine mit der Bezugszahl 22 bezeichnet ist. Die Schnappnase 22 ist mit einer (nicht gezeigten) schrägen Rampe gekoppelt, auf die mittels eines Schlüssels 24, der durch eine dem Schlüssel entsprechende Öffnung 26 gesteckt wird, gedrückt werden kann, wodurch die Schnappnase 22 und ihr Gegenstück auf der entgegengesetzten Seite gegen die elastische Rückstellkraft in Öffnungsrichtung verschoben werden, wodurch zwei in die Montagerahmen eingesetzte Funktionsmodule entriegelt werden können.

Die Montagerahmen 10 und 12 weisen noch zwei Auswurfstifte 28 und 30 auf, die federvorgespannt über die Frontseite der Montagerahmen hervorstehen. Wird ein Funktionsmodul eingesetzt, so wird der entsprechende Auswurfstift gegen die elastische Federkraft niedergedrückt. Bei Entriegelung mittels des Schlüssels 24 dient die Federkraft dazu, das Funktionsmodul aus dem Montagerahmen 10, 12 herauszudrücken.

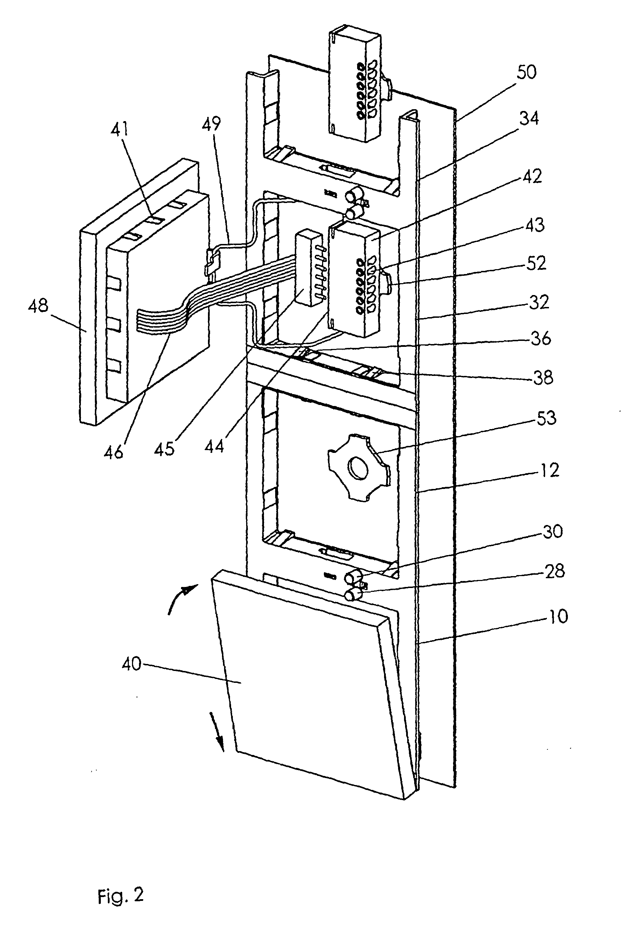

Fig. 2 zeigt eine Kombination von vier Montagerahmen 10, 12, 32 und 34. Wie im Falle des Montagerahmens 32 dargestellt, weist jeder Montagerahmen feststehende Nasen 36 und 38 auf der den Schnappnasen jeweils gegenüberliegenden Seite auf. Jedes Funktionsmodul weist rundherum Rasten auf, von denen eine beispielhaft mit der Bezugszahl 41 bezeichnet ist. Wie in Fig. 2 unten dargestellt, wird ein Funktionsmodul 40 eingesetzt, indem zunächst seine Rasten mit entsprechenden feststehenden Nasen in Eingriff gebracht werden, um dann im Wege einer Schwenkbewegung in die endgültige Stellung in dem Montagerahmen verschwenkt zu werden, wo es mit der jeweiligen Schnappnase verrastet. Die Auswurfstifte 28 und 30 werden dabei niedergedrückt.

In dem Montagerahmen 32 erkennt man ein Buchsen-Klemmen-Element 42, dessen Klemmen 43 dem elektrischen Anschluß an die Hausanlage dienen und dessen Buchse 44 dazu dient, einen Stecker 45 aufzunehmen, der über ein Kabel 46 mit einem Funktionselement 48 verbunden ist. Um zum Einstecken des Steckers beide Hände freizuhaben, ist ein Bügel 49 vorgesehen, mit dem das Funktionsmodul 48 vorübergehend an das Klemmen-Buchsen-Element 42 angehängt werden kann.

Bei den Funktionsmodulen kann es sich um beliebige Ausgestaltungen handeln, beispielsweise ein Informationsmodul, ein Tastenmodul, eine Kamera etc.

Das Buchsen-Klemmen-Element 42 wird an einer vom Montagerahmen unabhängigen Befestigungsebene, wie etwa dem Boden 50 des Kombinationsrahmens oder einer den Kombinationsrahmen haltenden Unter- oder Aufputzdose mittels eines Bajonettverschlusses 52 befestigt. Der Bajonettverschluß 52 ist so gestaltet, daß beliebige zueinander um 90° verdrehte Anbringungsstellungen möglich sind. Ein weiterer Bajonettverschluß ist mit 53 bezeichnet.

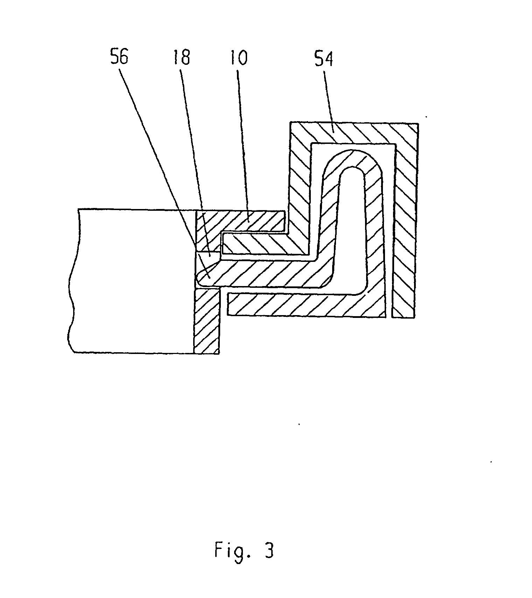

Fig. 3 zeigt die Verriegelung des Montagerahmens 10 an einem Kombinationsrahmen 54. Dazu weist der Kombinationsrahmen 54 eine elastisch in Schließrichtung vorgespannte Schnappnase 56 auf, die eine an einer Ausnehmung 18 ausgebildete Raste 56 hintergreift.

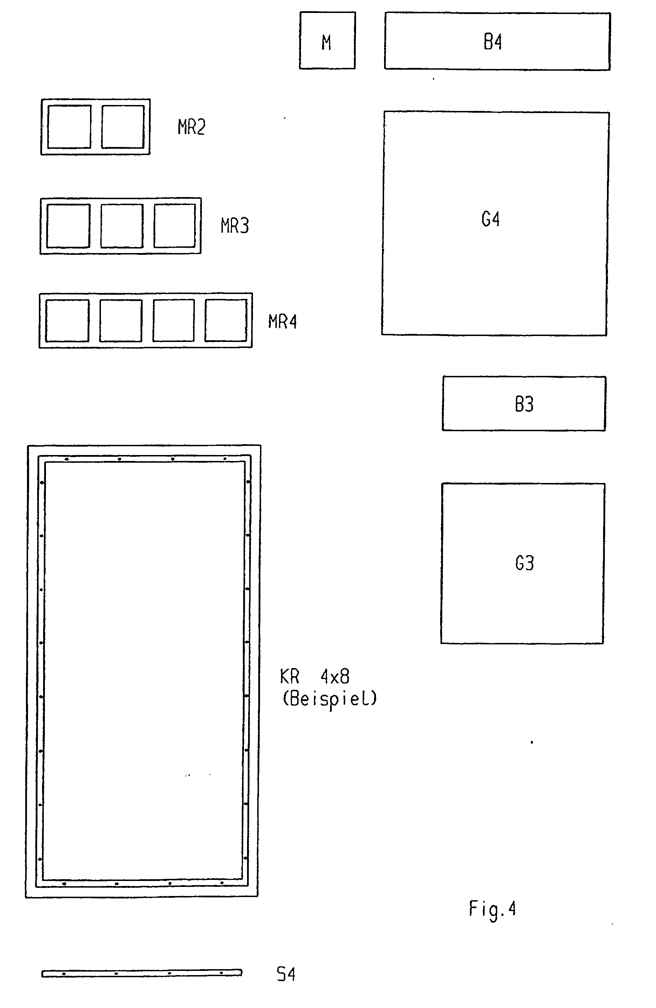

Fig. 4 zeigt verschiedene Elemente einer Türanlage: Verschiedene Kombinationen von Montagerahmen MR2, MR3 und MR4; ein Modul M; einen kleinen Briefkasten B4 mit der vierfachen Breite des Moduls M und einen kleinen Briefkasten B3 mit der dreifachen Breite des Moduls M; einen großen Briefkasten G4 mit den Abmessungen von 4 x 4 Modulen M und einen großen Briefkasten G3 mit den Abmessungen von 3 x 3 Modulen M; einen Kombinationsrahmen KR mit derartigen Abmessungen, daß 4 x 8 Module M hineinpassen, und eine Stabilisierungsrippe S4 mit der Breite von 4 Modulen M.

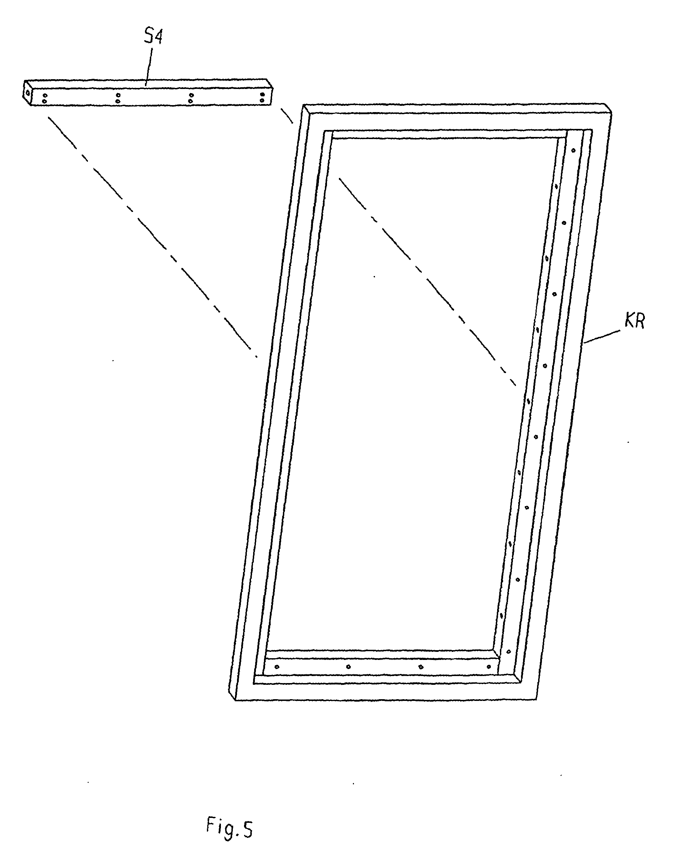

Fig. 5 zeigt einen Kombinationsrahmen KR mit einer Stabilisierungsrippe S4, wobei angedeutet ist, wie die Stabilisierungsrippe S4 an dem Kombinationsrahmen anzubringen ist. Zur Befestigung werden Schrauben verwendet.

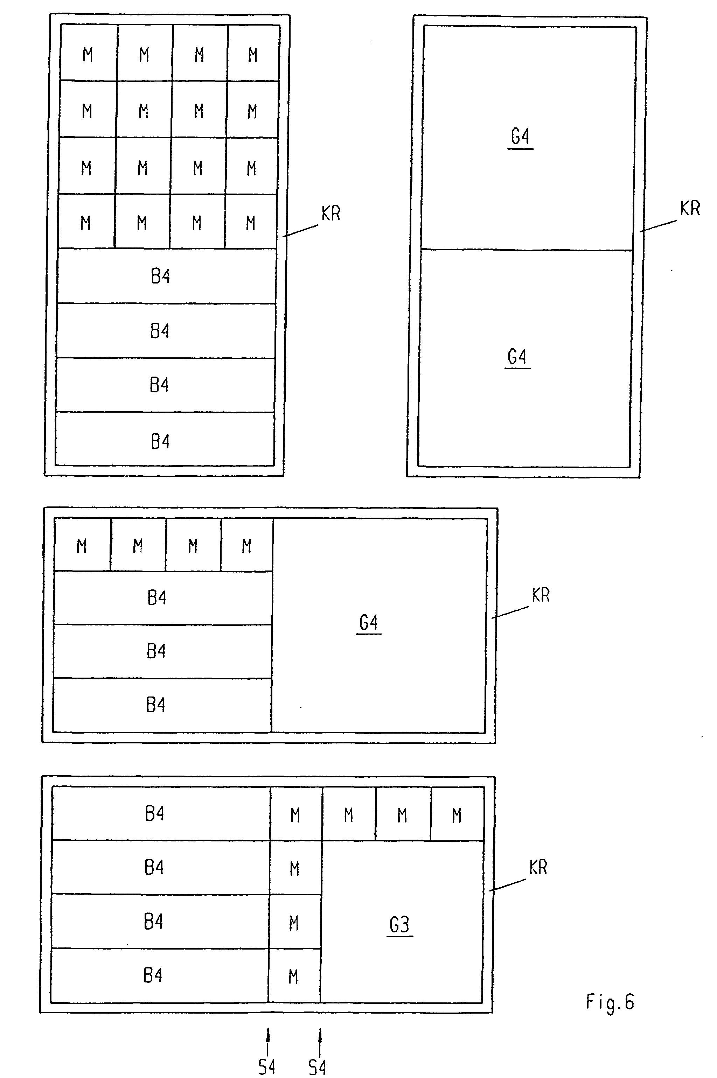

Fig. 6 zeigt verschiedene Bestückungsvariationen eines Rahmens mit den Abmessungen von 4 x 8 Funktionsmodulen. Man erkennt die überaus große Flexibilität des Systems. Bei den beiden unteren Versionen sind jeweils Stabilisierungsrippen S4 erforderlich, die dann auch die ansonsten an dem Kombinationsrahmen vorgesehenen Schnappnasen zur Verriegelung der Montagerahmen tragen.

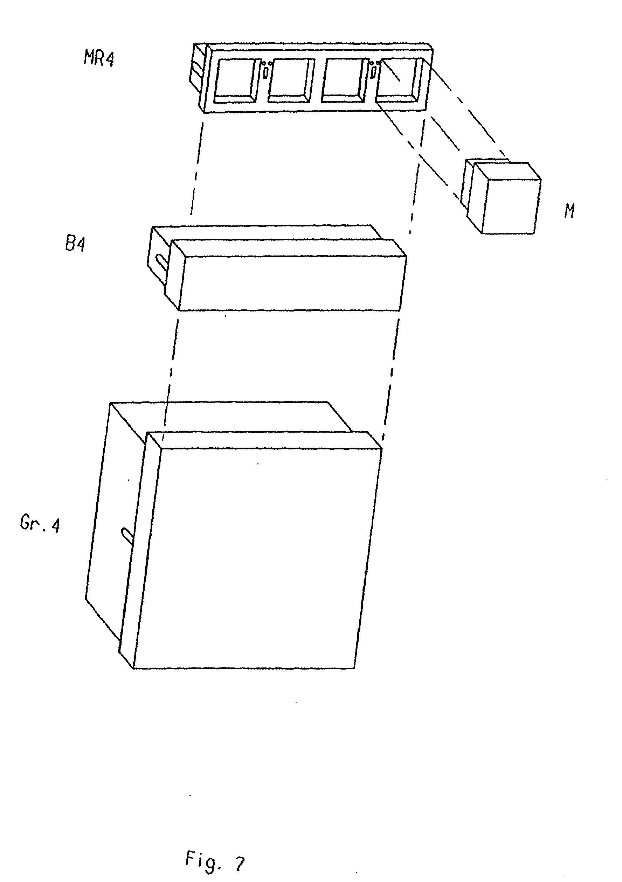

Fig. 7 zeigt perspektivisch einen Montagerahmen MR4, ein Modul M, einen kleinen Briefkasten B4 und einen großen Briefkasten G4. Fig. 7 ist zu entnehmen, daß allen Elementen dasselbe Raster zugrundeliegt. Ferner ist Fig. 7 zu entnehmen, daß die Außenabmessungen des Montagerahmens 4 mit den Außenabmessungen von darin aufgenommenen Modulen M fluchten, so daß zum einen auch insoweit das Raster nicht durchbrochen wird und zum anderen die der Verriegelung des Montagerahmens in dem Kombinationsrahmen dienenden Elemente 18, 56 (Fig. 3) verdeckt und unzugänglich sind. Allerdings ist jeweils zwischen zwei benachbarten Funktionsmodulen ein kleiner Spalt, durch den der Schlüssel 24 in den Schlitz 26 eingeführt werden kann (Fig. 1).

Die in der obigen Beschreibung, den Ansprüchen sowie der Zeichnung offenbarten Merkmale der Erfindung können sowohl einzeln als auch in beliebigen Kombinationen für die Verwirklichung der Erfindung in ihren verschiedenen Ausführungsformen wesentlich sein.

## Patentansprüche

1. Türanlage mit
mindestens einem Kombinationsrahmen (KR),
mindestens zwei Montagerahmen (10, 12, 32, 34) und
mindestens zwei Funktionsmodulen (40, 48),
wobei
die Montagerahmen (10, 12, 32, 34) dazu ausgelegt sind, jeweils ein Funktionsmodul (40, 48) aufzunehmen,
der Kombinationsrahmen (KR) dazu ausgelegt ist, mindestens zwei Montagerahmen (10, 12, 32, 34) aufzunehmen und
zwei erste Verriegelungseinrichtungen (22, 36, 38, 41) zum Verriegeln jeweils eines Funktionsmoduls (40, 48) in einem Montagerahmen (10, 12, 32, 34) vorgesehen sind,
**dadurch gekennzeichnet, daß**
die Montagerahmen (10, 12, 32, 34) starr miteinander verbunden sind, und zwar derart, daß die von ihnen aufgenommenen Funktionsmodule (40, 48) in einer Reihe nebeneinander liegen,
in der Draufsicht die Außenkontur der miteinander verbundenen Montagerahmen (10, 12, 32, 34) nicht über die Stirnseiten und die Längsseiten der Reihe Funktionsmodule (40, 48) übersteht und eine der Verriegelung der miteinander verbundenen Montagerahmen in dem Kombinationsrahmen dienende zweite Verriegelungseinrichtung (14, 16; 18, 56) derart angeordnet ist, daß sie von aufgenommenen Funktionsmodulen (40, 48) verdeckt wird und dadurch unzugänglich ist.

2. Türanlage nach Anspruch 1, **dadurch gekennzeichnet, daß** die zweite Verriegelungseinrichtung (14, 16; 18, 56) mindestens eine Schraube zum Einschrauben in eine Rückwand des Kombinationsrahmens (KR) oder in eine den Kombinationsrahmen (KR) haltende Unter- oder Aufputzdose beinhaltet.

3. Türanlage nach Anspruch 1 oder 2, **dadurch gekennzeichnet, daß** die zweite Verriegelungseinrichtung (14, 16; 18, 56, 41) mindestens eine elastisch in Schließrichtung vorgespannte Schnappnase (56) an den miteinander verbundenen Montagerahmen (10, 12, 32, 34) oder dem Kombinationsrahmen (KR) beinhaltet, die im Verriegelungszustand eine Raste (18) an dem Kombinationsrahmen (KR) oder den miteinander verbundenen Montagerahmen (10, 12, 32, 34) hintergreift.

4. Türanlage nach einem der vorangehenden Ansprüche, **gekennzeichnet durch** mindestens eine Stabilisierungsrippe (S4), die lösbar derart an dem Kombinationsrahmen (KR) befestigt ist, daß sie im Inneren des Kombinationsrahmens (KR) und parallel zu einer seiner Seiten liegt.

## Claims

1. Door system comprising at least one combination frame (KR), at least two mounting frames (10, 12, 32, 34) and at least two functional modules (40. 48). the mounting frames (10, 12, 32, 34) each being designed to receive a functional module (40, 48), the combination frame (KR) being designed to receive at least two mounting frames (10, 12, 32, 34) and two first locking means (22, 36, 38, 41) each for locking a respective functional module (40, 48) being provided in a mounting frame (10, 12, 32, 34), **characterised in that** the mounting frames (10, 12, 32, 34) are rigidly connected together, in such a manner that the functional modules (40, 48) received thereby are arranged in a row alongside one another, the outer contour of the mounting frames (10, 12, 32, 34) connected together does not project beyond the end faces and the longitudinal sides of the row of functional modules (40, 48) when viewed from above and a second locking means (14, 16; 18, 56) serving to lock the mounting frames connected together in the combination frame is arranged in such a manner that it is covered by functional modules (40, 48) received and is thus inaccessible.

2. Door system according to claim 1, **characterised in that** the second locking means (14, 16; 18, 56) contains at least one screw for screwing into a rear wall of the combination frame (KR) or into a flush-mounted or surface-mounted socket holding the combination frame (KR).

3. Door system according to claim 1 or claim 2, **characterised in that** the second locking means (14, 16; 18, 56, 41) contains at least one snap-in projection (56) spring-loaded in the closing direction on the mounting frames (10, 12, 32, 34) connected together or on the combination frame (KR) and engaging behind a stop notch (18) on the combination frame (KR) or on the mounting frames (10, 12, 32, 34) connected together in the locked state.

4. Door system according to one of the preceding claims, **characterised by** at least one stabilising rib (S4) removably fixed to the combination frame (KR) in such a manner that it is situated in the interior of the combination frame (KR) and parallel to one of its sides.

## Revendications

1. Installation de porte comportant
au moins un cadre de combinaison (KR),
au moins deux cadres de montage (10, 12, 32, 34) et
au moins deux modules de fonctionnement (40, 48), où
les cadres de montage (10, 12, 32, 34) sont conçus pour recevoir respectivement un module de fonctionnement (40, 48),
le cadre de combinaison (KR) est conçu pour recevoir au moins deux cadres de montage (10, 12, 32, 34) et
deux premiers dispositifs de verrouillage (22, 36, 38, 41) sont prévus pour verrouiller respectivement un module de fonctionnement (40, 48) dans un cadre de montage (10, 12, 32, 34),
**caractérisée en ce que**
les cadres de montage (10, 12, 32, 34) sont reliés rigidement entre eux et cela de façon que les modules de fonctionnement (40, 48) reçus par eux se situent dans une rangée les uns à côté des autres,
**en ce que**, vu de dessus, le contour extérieur des cadres de montage (10, 12, 32, 34) reliés entre eux ne dépasse pas des côtés frontaux et des côtés longitudinaux de la rangée de modules de fonctionnement (40, 48) et qu'un deuxième dispositif de verrouillage (14, 16 ; 18, 56) destiné au verrouillage des cadres de montage reliés entre eux dans le cadre de combinaison est disposé de façon qu'il soit recouvert par les modules de fonctionnement reçus (40, 48), et qu'il est donc inaccessible.

2. Installation de porte selon la revendication 1, **caractérisée en ce que** le deuxième dispositif de verrouillage (14, 16 ; 18, 58) comporte au moins une vis pour le vissage dans une paroi arrière du cadre de combinaison (KR) ou dans une boîte inférieure ou en saillie retenant le cadre de combinaison (KR).

3. Installation de porte selon la revendication 1 ou 2, **caractérisée en ce que** le deuxième dispositif de verrouillage (14, 16 ; 18, 56, 41) comporte au moins un talon d'enclenchement (56) précontraint élastiquement dans la direction de fermeture aux cadres de montage (10, 12, 32, 34) reliés entre eux ou au cadre de combinaison (KR) qui, à l'état de verrouillage, passe derrière un cran d'arrêt (18) au cadre de combinaison (KR) ou aux cadres de montage (10, 12, 32, 34) reliés entre eux.

4. Installation de porte selon l'une des revendications précédentes, **caractérisée par** au moins une nervure de stabilisation (S4) qui est fixée amoviblement de telle sorte au cadre de combinaison (KR) qu'elle se situe à l'intérieur du cadre de combinaison (KR) et parallèlement à l'un de ses côtés.
